# EUROPEAN PATENT APPLICATION

(11) **EP 2 838 111 A1**
(43) Date of publication of application: **18.02.2015**
(21) Application number: 14180827.9
(22) Date of filing: 13.08.2014
(51) Int. Cl.: H01L 21/306

(54) **Methods for cleaning a wafer edge including a notch**

(30) Priority: 14.08.2013 US 201313967160
(71) Applicant: Applied Materials, Inc., Santa Clara, CA 95054 (US)
(72) Inventor: Hanson, Kyle M., Kalispell, MT Montana 59901 (US); Peterson, Joy E., Kalispell, MT Montana 59901 (US)
(74) Representative: Zimmermann & Partner

(57) **Abstract**

In a method for removing metal at the edge of a wafer, including from a notch in the edge of the wafer, water is dripped or otherwise supplied onto the up-facing metal-plated front side of the wafer, while rotating the wafer. A metal etchant, such as sulfuric acid, is provided onto the back side of the wafer, at a flow rate multiple times greater than the water flow rate. The etchant flows over the edge of the wafer and the notch, and onto an annular edge on the front side of the wafer, or the etchant diffuses into the water at the edge of the wafer. The metal plated in the notch is removed, even if the notch has a radial depth greater than the width of the exclusion zone. The flow rates of the water and the etchant, and the rotation speed may be adjusted to provide a static water film, with the etchant diffusing into the outer edge of the water film.

## Description

### FIELD OF THE INVENTION

The field of the invention is methods for cleaning work pieces or substrates, such as semiconductor material wafers.

### BACKGROUND OF THE INVENTION

In the processing a semiconductor material wafer or similar substrate, the side or surface of the wafer on which micro-scale devices (such as microelectronic circuits) are formed is called the front side or the device side. The other side is referred to as the back or bottom side of the wafer. In general one or more layers or films of metal or other conductor is typically applied onto front side the wafer. During this process metal may also get onto the wafer edge. To avoid downstream contamination, and for other reasons, the metal on the edge is removed in an etching process to form an annular edge exclusion zone or area on the front side of the wafer extending typically 1-3 mm in from the edge.

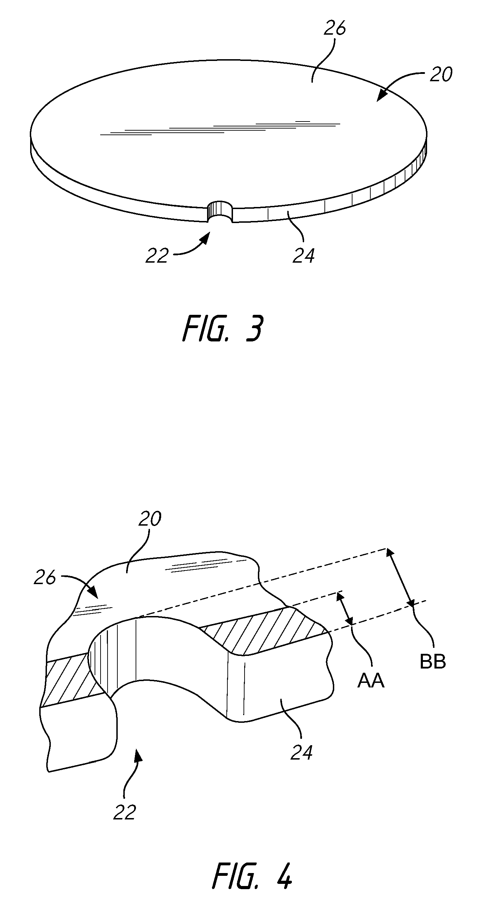

The etching process is typically performed by rotating the wafer while applying one or more etchants and/or other liquids or gases onto the wafer. Referring to Figs. 3 and 4, many wafers 20 have a notch 22 in the wafer edge 24 indicating a specific crystal orientation of the wafer material. The dimensions of the notch are set by SEMI (Semiconductor Industry standards), with the notch having a radial depth of 1.25 mm. During the metal application step(s), metal deposits onto or into the notch. Generally the metal in the notch must be removed along with the metal in the exclusion zone. This presents engineering challenges.

It is an object of the invention to provide methods for removing plated metal from the edge of a wafer or other work piece, including from one or more notches in the edge of the wafer.

### SUMMARY

In light of the above, a method for processing a wafer having a metal-plated film according to independent claim 1, a method for processing a wafer having a metal film in a notch at an edge of the wafer according to independent claim 10 and a method for processing a wafer having a metal-plated film in a notch are provided. Further advantages, features, aspects and details are evident from the dependent claims, the description and the drawings.

### BRIEF DESCRIPTION OF THE DRAWINGS

Fig. 1 is a perspective view of a prior art processor for use in etching a wafer.
Fig. 2 is a top view of the processor shown in Fig. 1.
Fig. 3 is a schematic diagram of a prior art wafer having a notch.
Fig. 4 is an enlarged diagram of the notch shown in Fig. 3.

### DETAILED DESCRIPTION

To maximize yield from wafers, the width of the exclusion zone shown at AA in Fig. 4 is increasingly minimized. In the past an edge exclusion zone of 2 mm was often used. Since the notch depth BB in Fig. 4 is 1.25 mm in accordance with industry standards, cleaning metal from the notch was easily achieved with an exclusion zone of 2 mm, since the etchant would move fully into and over the notch during the etch process.

Currently, the width of the exclusion zone AA may be as little as 1.5 mm, 1.25 mm, or even less. This means that the notch depth may now exceed the width of the exclusion zone AA, as is shown in Fig. 4. Testing shows that as the width of the exclusion zone AA decreases, removing metal at the notch during etching becomes more difficult. With a specified exclusion zone AA of 1.25 mm or less, the metal plated film or metal seed layer may not be sufficiently removed or cleaned from the notch 22, when using known etching techniques. Since metal plated films are thicker than metal seed layers, removing metal plated films from the notch is much more difficult than removing a seed layer.

A new method has now been developed for removing or cleaning away metal from the notch, even with an exclusion zone of 1.50 mm, 1.25 mm, 1.0 mm or less. The method may be performed by the following steps:

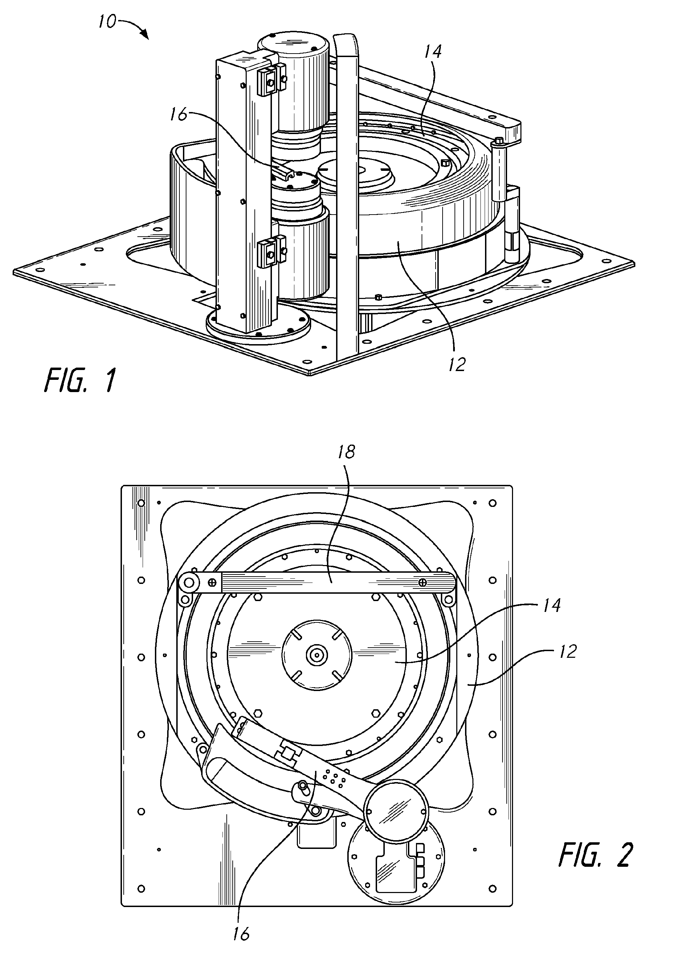

A. Placing the wafer 20 into an etch processor, such as the processor 10 shown in Figs. 1 and 2, with the device or front side 26 of the wafer face up.

B. Forming a thin film of liquid on the front side 26. This step may be performed by positioning the de-ionized (DI) water swing arm 18 of the processor 10 over a central position of the wafer and dripping DI water onto the wafer, while also rotating the wafer 20.

C. Applying an etchant to the (down-facing) back side of the rotating wafer. The etchant may be selected depending on the metal or other material to be etched. For example, an etchant including sulfuric acid, hydrogen peroxide and water may be used to etch copper. The etchant moves radially outwardly so that it contacts the entire perimeter of the wafer, including the notch 22. The etchant also moves over or around the edge 24 onto the outer 0.3 to 0.7 mm perimeter of the top side 26 of the wafer, where it comes into contact with the front-side film of DI water formed in step B. The etchant diffuses into the front-side water film and etches the metal film in the notch. This allows the metal at the notch 22 to be removed locally before etching the exclusion zone AA on the top side, regardless of the exclusion zone width. The exclusion zone is typically created in a separate etching process, which may be performed before or after the notch cleaning step. Accordingly, the notch cleaning process may be specifically designed for cleaning the notch, with a separate exclusion zone forming etching process used for forming the exclusion zone.

### DISCUSSION

The following discussion is directed to 300 mm diameter wafers. In the method described, etchant is applied only to the down-facing back side of the wafer, with DI water applied to the front side 26. The variables that may be adjusted are the backside etchant flow rate, the wafer rotation speed (RPM), and the front side DI drip flow rate.

The volume flow of the DI water dripped onto the front side may be sufficiently low that the DI water film is essentially a static film. For example, with a 300 mm diameter wafer and a DI water front side flow rate of 26 mL/min, the volume of water making up the water film on the front side (π x 150 x 150 x film thickness) is greater than the volume of liquid flowing each minute (26 mL in this example). As a result, the water film may be substantially static, while the etchant moves around the edge 24 and onto the top side where it comes into contact with the outer edge of the water film. At the static boundary between them, the etchant diffuses into the outer circumferential edge of the water film.

The front side DI water flow rate may range from 10-60 or 20-40 mL/min. The flow rate of the etchant applied to the back side (typically at the center of the back side of the wafer) is at least five, ten, 20 or 40 times greater than the flow rate of the front side DI water.

The flow rates of the DI water and the etchant, and the rotation speed may be adjusted or balanced to provide a static annular boundary on the front side of the wafer between etchant and the water. That is the circumference where the etchant abuts the water may be fixed and not move radially inwardly or outwardly during the process.

In a modification of the process described above, metal may be removed from the notch by etching, and the exclusion zone AA formed on the front side 26 or the wafer without using any front side DI water drip. However, this may result in excessive and irregular inward etch egress at the notch. If this etch egress is acceptable in the specific application, then the process may be performed without front side DI water drip, for example using a backside etchant flow rate of 450-850 mL/min or 550-750 mL/min of sulfuric acid standard dilution, and wafer rotation at 900-13 rpm or 1000-1200 rpm. Alternatively, the etchant flow rate may be reduced to 300 or 350 mL/min and the rotation speed reduced to 400-600 rpm, again without DI water or other fluid applied onto the front side 26.

Where front-side DI water drip is used, a DI water flow rate of 10-60 or 20-30 mL/min or 24-28 mL/min may be used, with a back side etchant flow rate proportionally greater by a factor of at least 5 or 10, and more typically by a factor of 20, 30 or 40, and with a wafer rotation of 300-1100 or 400-1000 rpm. Test results using the following parameters demonstrated full removal of metal from the notch:
1. Back side etchant flow rate 650 mL/min; front side DI water drip rate of zero, and 1100 rpm.
2. Back side etchant flow rate 650 mL/min; front side DI water drip rate of 26 mL/min, and 500 rpm.
3. Back side etchant flow rate 525 mL/min; front side DI water drip rate of 26 mL/min, and 500 rpm.
4. Back side etchant flow rate 350 mL/min; front side DI water drip rate of zero, and 500 rpm. In these tests plated copper was removed from the notch by etching in less than 60 seconds, generally in about 5-10 or 5-20 seconds.

Test results also demonstrated that using a back side etchant flow rate 350 mL/min; front side DI water drip rate of 26 mL/min, and 1100 rpm did not remove metal from the notch.

The front-side DI water drip helps to prevent inadvertent etching of the metal film inwardly of the exclusion zone AA.

The methods described are useful with wafers plated using a wet-contact ring technique, where a relatively thick film of metal is plated over the entire top surface 26 of the wafer, and in the notch. These types of wafers may have a film of metal on the notch having a thickness of 0.5 to 3 microns, or more, as there is no reduction in plating thickness at the wafer edge (in contrast to wafers plated with a sealed contact ring--where only a seed layer having a thickness of e.g. 0.1 microns or less is in the notch.

As used here, a metal plated film means a metal film plated onto a wafer via electro-chemical or electro less methods, and not a seed layer as applied onto a wafer using other techniques.

According to some embodiments, in a method for removing metal at the edge of a wafer, including from a notch in the edge of the wafer, water is dripped or otherwise supplied onto the up-facing metal-plated front side of the wafer, while rotating the wafer. A metal etchant, such as sulfuric acid, is provided onto the back side of the wafer, at a flow rate multiple times greater than the water flow rate. The etchant flows over the edge of the wafer and the notch, and onto an annular edge on the front side of the wafer, or the etchant diffuses into the water at the edge of the wafer. The metal plated in the notch is removed, even if the notch has a radial depth greater than the width of the exclusion zone. The flow rates of the water and the etchant, and the rotation speed may be adjusted to provide a static water film, with the etchant diffusing into the outer edge of the water film.

## Claims

1. A method for processing a wafer having a metal-plated film, comprising:
placing the wafer into or onto a rotor in a processor;
rotating the wafer;
applying de-ionized water onto an up-facing front side of the wafer at a first flow rate;
applying an etchant onto a down-facing back side of the wafer at a second flow rate, with the second flow rate at last five times greater than the first flow rate, with the etchant diffusing into the water at an edge of the wafer having a notch, and with the etchant removing metal-plated film from the notch.

2. The method of claim 1 with the wafer including an exclusion zone having a width of 1.5 mm or less formed on the front side of the wafer, particularly wherein the edge exclusion zone has a width of less than 1.25 mm..

3. The method of any of claims 1 to 2 with the second flow rate at least 20 times greater than the first flow rate.

4. The method of any of claims 1 to 3 with the metal plated film comprising a copper film having a thickness of at least 0.5 microns and with etchant comprising sulfuric acid, the second flow rate exceeding 450 mL/min and rotating the wafer at 500-1200 rpm.

5. The method of claim 4 with the wafer having a diameter of 300 mm and with the de-ionized water forming a water film boundary line on the front side of the wafer within 0.7 mm of the edge of the wafer, and with the etchant flowing around the edge of the wafer and onto the front side of the wafer where the etchant contacts the boundary line.

6. The method of any of claims 1 to 5 with the metal-plated film having a uniform thickness on the wafer.

7. The method of any of claims 1 to 6 with the metal plated film comprising a copper film electroplated onto the wafer via a wet contact ring.

8. The method of any of claims 2 to 7 wherein the notch has a radial depth greater than the width of the exclusion zone.

9. The method of any of claims 1 to 8 wherein the first flow rate, the second flow rate, and the rotation speed are selected to create a static annular boundary on the front side of the wafer between etchant and the water.

10. A method for processing a wafer having a metal film in a notch at an edge of the wafer, comprising:
rotating the wafer;
applying a first liquid onto an up-facing front side of the wafer at a first flow rate;
applying a second liquid onto a down-facing back side of the wafer at a second flow rate, with the second liquid comprising a metal etchant and the second liquid flowing around an edge of the wafer and over the notch, and onto an annular outer edge on the front side of the wafer with the etchant removing metal-plated film from the notch; and
controlling the first flow rate, the second flow rate, and the rotation speed to create a static annular boundary on the front side of the wafer between the etchant and the first liquid.

11. The method of claim 10 with the first liquid comprising water, and with the second flow rate 5-15 times greater than the first flow rate.

12. The method of any of claims 10 to 11 with the metal film in the notch having a thickness of 0.5 to 3 microns.

13. The method of any of claims 10 to 12 with the exclusion zone having a width of 1-1.5 mm.

14. A method for processing a wafer having a metal-plated film in a notch, comprising:
performing a notch cleaning step that includes: rotating the wafer; applying water onto an up-facing front side of the wafer at a first flow rate; applying an etchant onto a down-facing back side of the wafer at a second flow rate at last five times greater than the first flow rate, with the etchant flowing over the notch and onto the front side of the wafer, and with the etchant removing metal-plated film from the notch; and
performing a separate etch process to create an edge exclusion zone on the front side of the wafer having a width of less than 1.5 mm; and with either notch cleaning step or the separate etch process performed before the other.

15. The method of claim 14 with second flow rate at least 25 times greater than the first flow rate.
